(19) Europäisches Patentamt / European Patent Office / Office européen des brevets

(11) **EP 2 113 780 B1**

(12) **EUROPEAN PATENT SPECIFICATION**

(45) Date of publication and mention
of the grant of the patent:
**05.01.2011 Bulletin 2011/01**

(51) Int Cl.:
*G01R 31/34* (2006.01)     *G01R 31/06* (2006.01)
*H02K 15/02* (2006.01)

(21) Application number: **04791386.8**

(22) Date of filing: **26.10.2004**

(86) International application number:
**PCT/ES2004/000467**

(87) International publication number:
**WO 2006/048470 (11.05.2006 Gazette 2006/19)**

(54) **SQUIRREL-CAGE ASYNCHRONOUS MOTOR AND FAULT-DETECTION METHOD THEREFOR**

HAMSTERKÄFIG-ASYNCHRONMOTOR UND FEHLERDETEKTIONSVERFAHREN DAFÜR

MOTEUR ASYNCHRONE A CAGE D'ECUREUIL ET PROCEDE DE DETECTION DE PANNES DUDIT MOTEUR

(84) Designated Contracting States:
**AT BE BG CH CY CZ DE DK EE ES FI FR GB GR HU IE IT LI LU MC NL PL PT RO SE SI SK TR**

(43) Date of publication of application:
**04.11.2009 Bulletin 2009/45**

(73) Proprietor: **TSK Electronica y Electricidad, S.A.
33205 Gijon (Asturias) (ES)**

(72) Inventors:
• **PEDRAYES GONZALEZ, Francisco
UNIVERSIDAD DE OVIEDO
GIJON, ES-33204 (ES)**
• **RUIZ GONZALEZ, Miriam
UNIVERSIDAD DE OVIEDO
Dpto.
GIJON, ES-33204 (ES)**
• **FERNANDEZ CABANAS, Manes
UNIVERSIDAD DE OVIEDO
GIJON, ES-33204 (ES)**
• **GARCIA MELERO, Manuel
UNIVERSIDAD DE OVIEDO
GIJON, ES-33204 (ES)**
• **ROJAS GARCIA, Carlos
UNIVERSIDAD DE OVIEDO
GIJON ES-33204 (ES)**
• **ALONSO ORCAJO, Gonzalo
UNIVERSIDAD DE OVIEDO
GIJON, ES-33204 (ES)**
• **CANO RODRIGUEZ, Jose, Manuel
UNIVERSIDAD DE OVIEDO
GIJON ES-33204 (ES)**

(74) Representative: **Carpintero Lopez, Francisco et al
Herrero & Asociados, S.L.
Alcalá 35
28014 Madrid (ES)**

(56) References cited:
DE-A1- 3 939 304          US-A- 3 506 914
US-A- 4 136 312           US-A- 4 996 486
US-A1- 2003 020 485       US-A1- 2003 057 961

## Description

## OBJECT OF THE INVENTION

The present invention relates to fault detection in electric machines.

More specifically, the object of the invention is to reliably detect damage caused to the bars and/or end rings of the rotor cage of squirrel-cage asynchronous motors, regardless of the type of load that they are working with, it being especially desirable to detect this type of faults even when the motor is working with loads whose opposing torque has an oscillating or pulsating component.

Another object of the invention is a squirrel-cage asynchronous motor that includes a means of detecting damage caused to the bars and/or short-circuit rings of the rotor cage under any type of load.

## BACKGROUND OF THE INVENTION

The three-phase asynchronous motor was invented by Dolivo Dobrowolsky in 1890, which had a squirrel cage-like rotor and used windings distributed on the stator. This motor presented a simple and robust construction that offered excellent features and low maintenance.

Asynchronous machines, which are also called induction machines, are characterised in that the speed at which the rotor rotates does not coincide with the synchronous speed determined by the input power frequency. These machines are classified into two types, according to the type of rotor: squirrel-cage or short-circuit rotor and wound or slip ring rotor. The rotor consists of a set of stacked laminates forming a cylinder with a series of grooves on its outer perimeter where the field winding is disposed. The squirrel-cage rotor consists of a series of copper or aluminium conductors short-circuited by two end rings, and it is this particular formation that gives these motors their name. For its part, the stator has a series of radial teeth on its inner perimeter, which therebetween define a series of grooves into which the field winding fits.

One of the most common faults in squirrel-cage asynchronous motors is a broken or cracked rotor bar and/or end ring. This fault is particularly serious when there is a possibility of a fragment of the bar or ring flying off into the air gap of the machine, often causing very serious damage to the stator winding. For this reason, since the beginning of the 1980s attempts have been made to develop many techniques that are capable of detecting the fault early on in order to prevent a more serious fault occurring subsequently and to avoid the affected machine being out of service for a long period of time. US 4 808 932, US 3 875 511 and US 4 136 312 disclose fault detection approaches for induction motors.

Industrially used methods are mainly based on the search for certain harmonics components of the supply current or other variables such as the motor's leakage flux. Although these methods based on measuring external variables of the machine are effective, they have a significant limitation: they cannot be applied if the machine actuates a device whose opposing torque is of the oscillating type, as the effect of a broken bar and the oscillation of the load torque can be confused with one another in these working conditions. In fact, the most widely-used method for detecting this fault, which is based on analysing the frequency of the motor's supply current, is thoroughly affected by this phenomenon, being inapplicable if the motor actuates a load with a pulsating torque (reduction gear, mill, etc.).

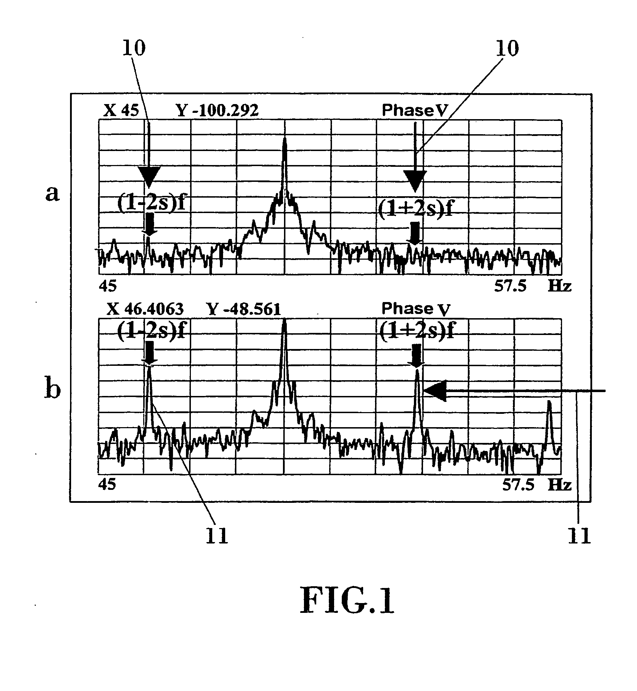

Figure 1 shows two supply current spectrums corresponding to a healthy new motor in which an oscillating component has been introduced in the frequency torque (2sf), (s) being the slip with which the machine works. In figure 1 a it is possible to observe how the harmonics (10) of frequencies $(1+2s)f$ and $(1-2s)f$ conventionally used to detect broken bars undergo a strong rise, peaks (11) in figure 1b, with the oscillation of the torque leading to an incorrect diagnosis, which would point to several broken rotor bars. As is the case with currents, the other variables used in the other methods of diagnosis that are currently available are also affected by the presence of loads with a pulsating torque.

No method is known in the state of the art that is capable of detecting this type of fault in the presence of loads with a pulsating torque.

## DESCRIPTION OF THE INVENTION

The present invention solves the technical problem posed, by means of the invention comprised in the attached independent claims 1 and 5.

More specifically, the method of the invention as defined in claim 1 makes it possible to detect the presence of damaged or broken bars in the rotor cage of squirrel-cage asynchronous motors in any load condition, including that corresponding to the actuation of machines whose opposing mechanical torque has oscillating components, like those presented for example with loads such as: mills, grinding machines, crushers, motors attached to multiple reduction gears, pumps, fans, etc.

The method of diagnosis is based on evaluating the alterations that occur in the positions of the axes of the machine's magnetic poles when there is an asymmetry in the rotor, i.e. broken rotor bars and/or short-circuit rings. It has been found that when an asynchronous machine has a broken rotor bar, a variation in the position of the axes of the motor's magnetic poles occurs that in turn gives rise to an alteration in the angle covered by each pole.

Broken bars cause a displacement of the magnetic axes of each magnetic pole, and this displacement of the magnetic axes in turn causes a significant alteration in the length covered by each pole over the machine's air gap, and this alteration is the parameter that is taken as an indicator for detecting the fault. These variations in the length of the magnetic poles can be detected by measuring the flux concatenated or linkage by one of the stator teeth, it thus being possible to diagnose the fault.

However, when the motor actuates a machine whose opposing torque has an oscillating component, there is no variation in the position of the axes of the magnetic poles or in their length. The oscillation of the load torque can cause substantial variations in the machine's maximum flux values, but it will not give rise to variations in the length of the magnetic poles. Therefore, the two phenomena: broken rotor bars and oscillation of the load torque, will be clearly differentiated, thus making the process of diagnosis simple and reliable.

Therefore, a first aspect of the invention relates to a fault-detection method for squirrel-cage asynchronous motors that is designed to detect damage to the rotor cage bars and/or the end rings of said motors, in any load condition, which is based on measuring the magnetic flux concatenated in one of the motor's stator teeth and taking said measurement as an indicator of the presence of damage to said bars and/or end rings.

Said magnetic flux is measured or analysed by determining the value of the electromotive force induced by said flux, in the terminals of an auxiliary coil situated around a stator tooth. According to Lenz's law, the electromotive force induced in the terminals of the auxiliary coil will be proportionate to the number of loops in the coil and to the instantaneous variation of the flux concatenated by it:

$$E = N \cdot d\Phi/dt;$$

where E is the electromotive force, N the number of loops in the auxiliary winding and $\Phi$ the flux concatenated by the machine's tooth.

Therefore, all alterations undergone by the motor's flux as a consequence of the insulation fault will be reflected in the electromotive force induced in the auxiliary coil. In fact, it has been proven that the variation in the length of the magnetic poles caused by the broken bars can be detected in the signal of the electromotive force induced in the auxiliary winding.

The way of detecting the magnetic alteration caused by the fault in the electromotive force induced is extremely simple: as has been mentioned above, the broken bar brings about a modification in the position of the axis of the magnetic poles that in turn alters the length thereof in the machine's air gap. For any healthy asynchronous machine, supplied with a current frequency f Hz the flux wave, and therefore the wave of the electromotive force induced in the auxiliary coil, will be an essentially sinusoidal wave with a period of T=1/f. However, experiments have proven that a broken bar modifies this wave form, making the signal period fluctuate around the T value corresponding to the symmetrical machine with poles of identical lengths. Therefore, the fault can be detected in an extremely simple manner just by measuring the length of time between the successive passes through zero of the signal of the electromotive force induced in the terminals of the auxiliary winding installed on one of the machine's teeth.

Another aspect of the invention relates to a motor system as defined in claim 5 comprising a squirrel-cage asynchronous motor, which includes the means of detecting the presence of damaged or broken bars in the rotor cage in any load condition, even with pulsating loads. For this, at least one auxiliary coil is positioned inside the motor, consisting of one or more loops of an insulated conductor around one of the stator teeth, said coil being suitably positioned and calculated for correctly measuring the magnetic flux created by the stator tooth.

The two ends or terminals of this coil are taken out of the machine where they can end in the motor's connection box or at the entrance to the diagnosis system or the measuring instrument used by the maintenance personnel to apply the detection method that is the object of the invention.

One of the advantages of the invention is that it can easily be integrated into an electronic real-time diagnosis device. In this case, it would be sufficient to design an electronic circuit to measure the period of the signal from the additional coil introduced in the machine and to define a threshold for the oscillations of this variable above which it is considered that there is a fault. The electronic system could be based on a low-cost microcontroller and its functions could include the machine's evaluation record, the handling of protection elements and alarms, etc.

The method that is the object of the invention has several advantages over the conventional procedures used to detect asymmetries in the rotor cage of squirrel-cage asynchronous motors:

  i.- It makes it possible to detect the fault in a pulsating mechanical load condition in which it is not possible to apply any other method of diagnosis that is not influenced by the effect of the load actuated by the motor.

  ii.- It does not require mathematical transformations to be performed with regard to the frequency, making the fault-detection system simpler and much less expensive.

  iii.- The diagnosis is carried out in real time and the detection device can be integrated into the machine itself to act as a warning, alarm or protection element, stopping the motor from working when the fault is first detected.

The features that the new method of diagnosis can offer, both in its direct application and if integrated into an electronic real-time fault-detection device, are as follows:

i.- Direct detection of broken or cracked bars and/or end rings of squirrel-cage asynchronous motors of any power range, number of poles, manufacturing technology and geometrical dimensions.

ii.- Differentiation between broken bars and the effect caused by oscillations in the opposing torque of the machine actuated by the motor. It is therefore possible to perform a diagnosis in any load condition, even in machines with opposing torques of very variable characteristics: mills, grinding machines, crushers, motors attached to multiple reduction gears, pumps, fans, etc.

iii.- Direct diagnosis without the need for the user to process the signal if the procedure is integrated into an electronic real-time fault-detection device.

iv.- Possibility of including the real-time detection device in the conventional machine-protection systems.

v.- Possibility of manually applying the method using only the flux-measuring loop without the need for any additional electronic system.

vi.- Possibility of integrating the method and the real-time detection system into the machine during its design and manufacture phase, specifically adapting the sensitivity thresholds to each motor.

vii.- Possibility of implementing the method in machines that are already in service in a simple manner and at a very low economic cost.

viii.- Possibility of transmitting the output signal of the system of the invention remotely: centralisation of the diagnosis process in industrial plants.

## DESCRIPTION OF THE DRAWINGS

To complement this description and in order to aid a better understanding of the invention's characteristics, according to a preferred practical embodiment thereof, there is a set of illustrative and non-limiting drawings integral to said description, which are as follows:

Figure 1 shows two graphs showing the current spectrum before and after introducing an oscillating component with a frequency of 2sf in the opposing torque of a healthy 11 kW motor. Graph 1 a corresponds to the current spectrum without a pulsating torque, and graph 1b shows the spectrum after introducing a pulsating torque. The horizontal axis corresponds to frequencies in hertz (Hz) and the vertical axis corresponds to the current value.

Figure 2 shows a simplified image of the front section of the rotor and the stator of a squirrel-cage motor, which shows the effect of the displacement of the axis of the machine's magnetic poles when there is a broken rotor bar. Figure 2a corresponds to a healthy motor, and figure 2b corresponds to a motor with a broken bar.

Figure 3 is a similar image to that of the previous figure, obtained from a simulation using the finite element method for an 11 kW, 400 V,

Figure 4 4-pole motor. Figure 3a corresponds to a healthy motor, and figure 3b corresponds to a motor with a broken bar. shows a schematic partially cross-sectioned perspective view of the rotor and the stator of a squirrel-cage motor.

Figure 5 shows an enlarged detail of the previous figure.

Figure 6 shows a similar detail to that of figure 5, which is further enlarged.

Figure 7 shows a block diagram describing the method that is the object of the invention for detecting rotor asymmetries.

Figure 8 shows a series of graphs corresponding to the experimental results of applying the method of the invention to a healthy motor and to a motor with a broken bar working with a constant and oscillating torque. These graphs show the duration of the half-period T/2 of the signal of the electromotive force induced in a stator tooth depending on the number of half-cycles of the signal that is captured. The horizontal axis of the graphs corresponds to the number of half-periods, and the vertical axis corresponds to the duration of the half-period in milliseconds (ms).

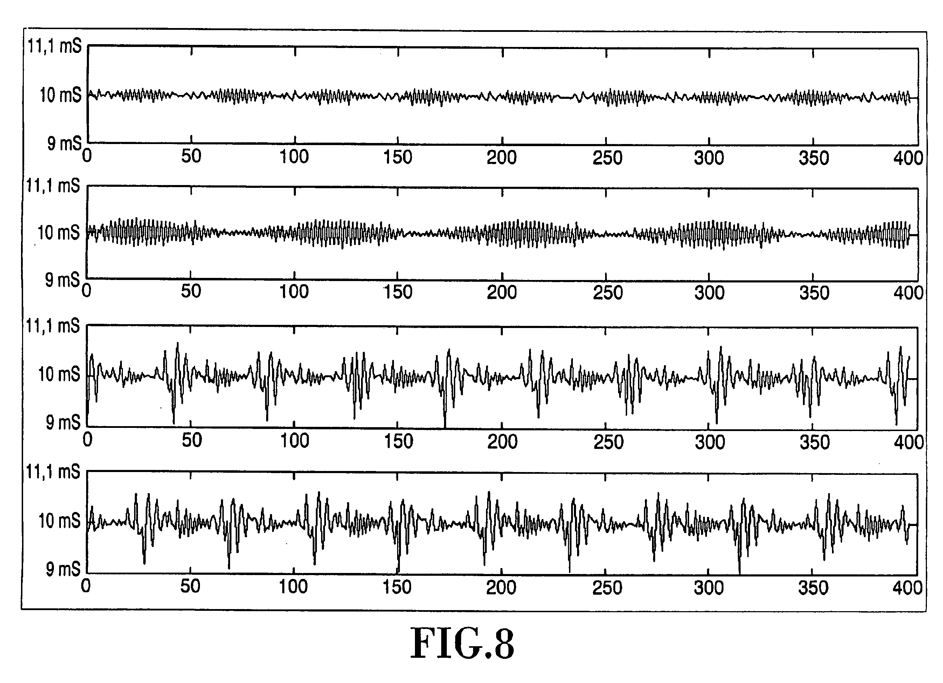

Graph 8a corresponds to a healthy motor working with a constant torque, figure 8b corresponds to a healthy motor working with an oscillating torque, figure 8c corresponds to a motor with a broken bar working with a constant torque, and figure 8d corresponds to a motor with a broken bar working with an oscillating torque.

## PREFERRED EMBODIMENT OF THE INVENTION

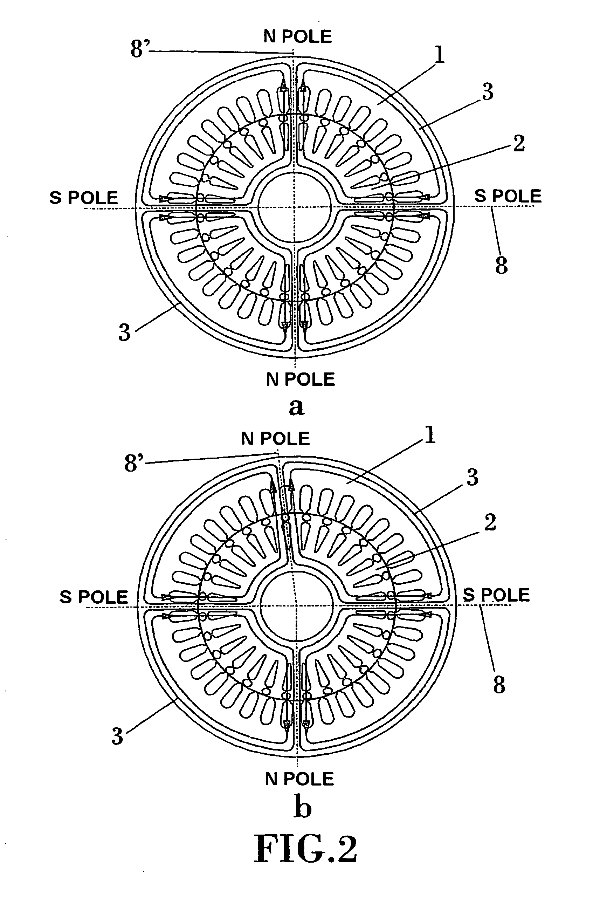

The method of diagnosis is based on an evaluation of the alterations that occur in the positions of the axes of the machine's magnetic poles when there is an asymmetry in the rotor, i.e. broken rotor bars and/or end rings. Figure 2 shows a simplified image of the stator (1) and the rotor (2) of a squirrel-cage asynchronous motor, and also shows the field lines (3) corresponding to a 4-pole motor. Figure 2a corresponds to a healthy motor and figure 2b corresponds to a motor with a broken rotor-cage bar. In said figure it can be observed that the broken bars (not shown) bring about a displacement in the magnetic axes (8,8') of each pole. This displacement of the magnetic axes (8,8') causes an alteration in the length of each of the poles, which is the parameter that will be taken as the means of detecting the fault.

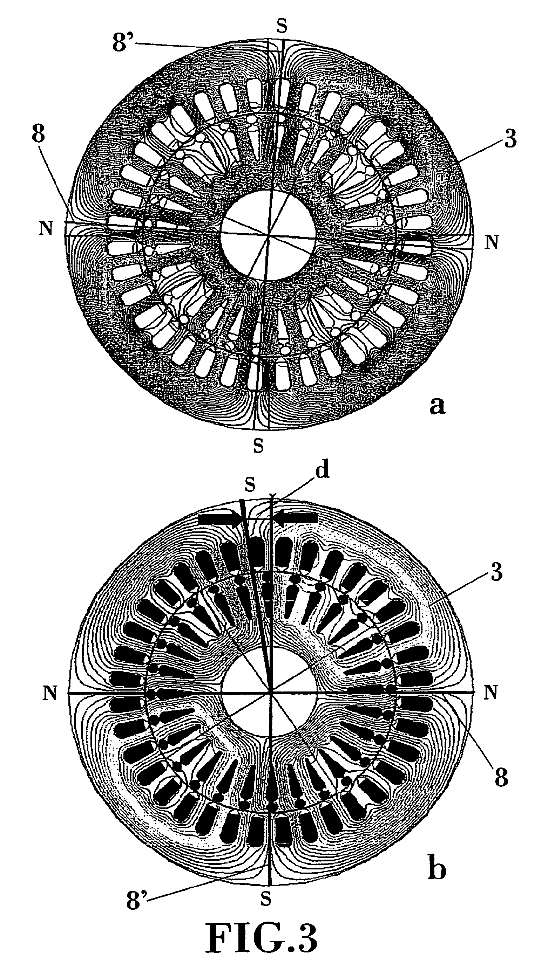

In order to observe the phenomenon described in the previous section in more detail, figure 3 shows two graphs obtained from a simulation of an 11 kW, 4-pole motor using the finite element method. In figure 3a it is possible to observe the distribution of the lines of the magnetic field (3) corresponding to the machine without any type of fault, and figure 3b shows the magnetic field (3) resulting from two broken rotor bars. In this graph it is possible to observe how the broken rotor bars have caused a significant displacement (d) in the axes (8,8') of the magnetic poles.

The displacement of the axes of the magnetic poles in turn causes a significant alteration in the length covered by each pole over the machine's air gap. These variations in the length of the magnetic poles can be detected by measuring the flux concatenated by one of the stator teeth (4) of the stator (1), thus making it possible to diagnose the fault even when the motor actuates a machine whose opposing torque has an oscillating component, as the measurement that is taken is not affected by the type of load.

The invention is based on measuring the magnetic flux on one of the teeth (4) of the machine's stator (1). To do this, several loops of insulated conductor are introduced in the motor around one of the stator teeth (4), forming an auxiliary coil (5). This small coil (5) is extremely simple and economical to make, as it is sufficient to apply the desired number of loops, either at the top or the bottom of the tooth (5), taking its two ends or terminals (7,7') out of the machine where they can end in the motor's connection box (not shown) or in the entrance to the diagnosis system or the measuring instrument used by the maintenance personnel to apply the new detection method.

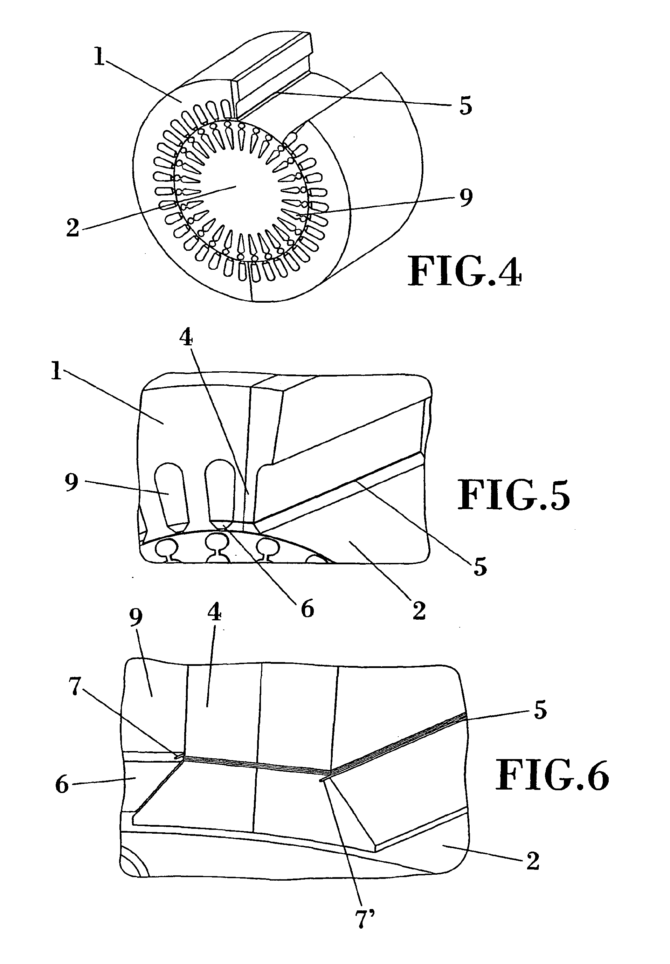

In the case of figure 6, the auxiliary coil (5) has been placed at the inner end of the stator tooth (4), just below the fastening wedge (6) of the stator winding (9).

As can be deduced from figures 4, 5 and 6, the costs of installation and the additional winding are practically insignificant.

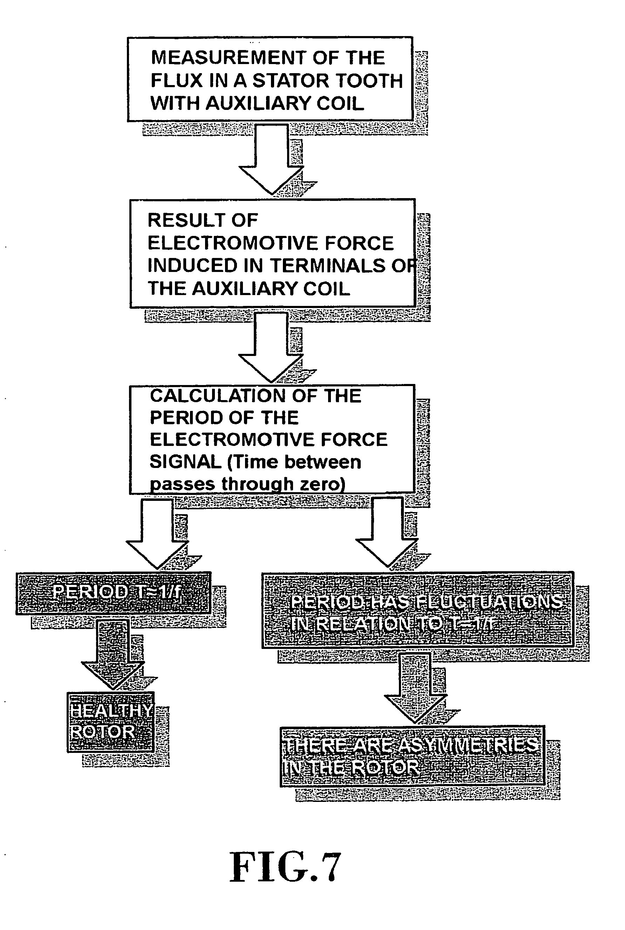

Figure 7 shows the main operational phases of the method of the invention. The procedure described in figure 7 can be put into practice in very different ways: it is possible to carry out all the aforementioned data processing on the digitally sampled electromotive force signal at a later time. In this case the electromotive force signal would be captured using a digital measuring instrument. Using the captured data, the period of the signal would be measured at a later time and a diagnosis would be made on the basis of the result obtained.

Figure 8 shows 4 graphs corresponding to the application of the procedure to an 11 k W, 4-pole, three-phase asynchronous motor. They show the duration of the half-period T/2 of the signal of the electromotive force induced in a tooth depending on the number of half-cycles of the signal that is captured. At the top there are two graphs for the healthy motor working with a constant torque and with an oscillating torque with a frequency of 2sf. The two graphs at the bottom correspond the same motor working in the same load condition but with a broken rotor bar.

In view of the four graphs, it is possible to determine the method's ability to detect broken bars, even in the most adverse load conditions with a pulsating torque because, as can be deduced from the similarity of the two pairs of graphs, the effect of the oscillation on the torque is practically negligible.

Several possibilities of practical embodiments of the invention are described in the attached dependent claims.

In view of this description and set of figures, a person skilled in the art will understand that the embodiments of the invention disclosed herein can be combined in many ways within the object of the invention. The invention has been described according to certain preferred embodiments thereof, but for a person skilled in the art it will be clear that many variations can be introduced to said preferred embodiments whilst adhering to the object of the claimed invention.

## Claims

1. Fault-detection method for detecting damage to the rotor cage bars and/or the short-circuit rings of a squirrel-cage asynchronous motor, said motor comprising a stator (1) and a rotor (2), the stator including a plurality of stator teeth (4) and the rotor including a plurality of rotor cage bars, wherein the motor is working under any load condition, said load condition including loads whose opposing torque has an oscillating or pulsating component,
said motor being supplied with at least one signal having a fequency (f)
wherein the method comprises the steps of:

   measuring the magnetic flux concatenated in one of the motor's stator teeth and taking said measurement as an indicator of the presence of damage to said bars and/or short-circuit rings, wherein said magnetic flux is measured by determining the value of the electromotive force induced by said flux in the terminals of an auxiliary coil (5) situated around said stator tooth, and wherein the period of the signal of said electromotive force is determined by measuring the length of time between the successive passes through zero of said signal, and wherein the period of the signal of said electromotive force is compared with the period corresponding to the frequency (f) of the motor power supply signal, and interpreting as an indicator of the presence of damage to the rotor-cage bars and/or short-circuit rings of said motor the fact that the value of the period measured for the signal of said electromotive force does not coincide with or is not close to the period corresponding to said frequency (f).

2. Method according to claim 1 , **characterised in that** to make said comparison a threshold value is defined, above which the result of the comparison is considered as an indicator of the presence of a fault.

3. Method according to claim 1, **characterised in that** the signal of the electromotive force is measured using a measuring instrument.

4. Method according to claim 3, **characterised in that** the measuring instrument is digital and **in that** the measurement thereby obtained is transmitted to a computerised equipment to diagnose said measurement.

5. Motor system comprising a squirrel-cage asynchronous motor, said motor comprising a rotor (2) housed inside a stator (1) that has multiple stator teeth (4) in a radial arrangement, wherein at least one auxiliary coil (5) is disposed around one of the stator teeth (4) for detecting damage to the rotor-cage bars and/or the short-circuit rings of said motor, when the motor is working under in any load condition including pulsating loads, said auxiliary coil being adapted to measure the magnetic flux concatenated on said stator tooth, wherein the auxiliary coil (5) has two terminals which are accessible from the outside of the motor in order to facilitate the electrical connection of an external measuring equipment to these terminals, the motor system further comprising programmable electronic means provided outside the motor to analyse the signal at the terminals of the auxiliary coil, said programmable electronic means being configured to implement the method defined in claim 1.

6. Motor system according to claim 5, **characterised in that** said auxiliary coil consists of at least one loop of an insulated conductor.

7. Motor system according to claims 5 or 7, **characterised in that** the auxiliary coil is disposed on the inner end of said stator tooth, on the outer end of said stator tooth or in any intermediate position between said ends.

8. Motor system according to claims 5 or 7, **characterised in that** the auxiliary coil is disposed parallel to the shaft of the motor.

9. Motor system according to claim 1, **characterised in that** said electronic means can transmit the result of the analysis or the signal present at the terminals of the auxiliary coil remotely.

**Patentansprüche**

1. Fehlererkennungsverfahren zum Erkennen von Beschädigungen der Rotorkäfigstangen und/oder der Kurzschlussringe eines Asynchron-Kurzschlussläufermotors, wobei der Motor einen Stator (1) und einen Rotor (2) aufweist, wobei der Stator mehrere Statorzähne (4) und der Rotor mehrere Rotorkäfigstangen aufweist, wobei der Motor unter jeder beliebigen Lastbedingung arbeitet, wobei die Lastbedingung Lasten umfasst, deren entgegengesetztes Drehmoment eine oszillierende oder pulsierende Komponente aufweist,
wobei dem Motor mindestens ein Signal mit einer Frequenz (f) zugeführt wird,
wobei das Verfahren die folgenden Schritte aufweist:

   Messen des konkatenierten Magnetflusses in einem der Statorzähne des Motors und Verwenden der Messung als Indikator für das Vorhandensein einer Beschädigung der Stangen und/oder der Kurzschlussringe,
   wobei der Magnetfluss gemessen wird, indem der Wert der durch den Fluss in die Anschlüsse einer um den Statorzahn herum befindlichen Hilfsspule (5) induzierten elektromotorischen Kraft bestimmt wird,
   und wobei die Periode des Signals der elektromotorischen Kraft durch Messen der Zeitspanne zwischen den aufeinanderfolgenden Nulldurchgängen des Signals bestimmt wird,
   und wobei die Periode des Signals der elektromotorischen Kraft mit der Periode verglichen wird, welche der Frequenz (f) des Motorstromversorgungssignals entspricht, und wobei die Tatsache, dass der für das Signal der elektromotorischen Kraft gemessene Wert der Periode nicht mit der der Frequenz (f) entsprechenden Periode koinzidiert oder dieser nahe ist, als Indikator für das Vorliegen einer Beschädigung der Rotorkäfigstangen und/oder der Kurzschlussringe des Motors interpretiert wird.

2. Verfahren nach Anspruch 1, **dadurch gekennzeichnet, dass** zur Durchführung des Vergleichs ein Schwellenwert definiert wird, oberhalb dessen das Ergebnis des Vergleichs als Indikator für das Vorhandensein eines Fehlers angesehen wird.

3. Verfahren nach Anspruch 1, **dadurch gekennzeichnet, dass** das Signal der elektromotorischen Kraft unter Verwendung eines Messinstruments gemessen wird.

4. Verfahren nach Anspruch 3, **dadurch gekenn-**

**zeichnet, dass** das Messinstrument digital ist und dass die damit erhaltene Messung an ein computerisiertes Gerät übertragen wird, um die Messung zu analysieren.

5. Motorsystem mit einem Asynchron-Kurzschlussläufermotor, wobei der Motor einen in einem mehrere radial angeordnete Statorzähne (4) aufweisenden Stator (1) aufgenommenen Rotor (2) aufweist, wobei mindestens eine Hilfsspule (5) um einen der Statorzähne (4) herum angeordnet ist, um Beschädigungen der Rotorkäfigstangen und/oder der Kurzschlussringe des Käfigs zu erkennen, wenn der Motor unter beliebigen Lastbedingungen, einschließlich pulsierenden Lasten, arbeitet, wobei die Hilfsspule zum Messen des konkatenierten Magnetflusses an dem Statorzahn geeignet ist, wobei die Hilfsspule (5) zwei Anschlüsse aufweist, die von außerhalb des Motors zugänglich sind, um den elektrischen Anschluss eines externen Messgeräts an diese Anschlüsse zu vereinfachen, wobei das Motorsystem ferner außerhalb des Motors befindliche, programmierbare elektronische Einrichtungen zum Analysieren des Signals an den Anschlüssen der Hilfsspule aufweist, wobei die programmierbaren elektronischen Einrichtungen zur Durchführung des Verfahrens nach Anspruch 1 ausgebildet sind.

6. Motorsystem nach Anspruch 5, **dadurch gekennzeichnet, dass** die Hilfsspule aus mindestens einer Schleife eines isolierten Leiters besteht.

7. Motorsystem nach Anspruch 5 oder 6, **dadurch gekennzeichnet, dass** die Hilfsspule an dem inneren Ende des Statorzahns, am äußeren Ende des Statorzahns oder an jeder Zwischenposition zwischen den Enden angeordnet sein kann.

8. Motorsystem nach den Ansprüchen 5 bis 7, **dadurch gekennzeichnet, dass** die Hilfsspule parallel zur Motorwelle angeordnet ist.

9. Motorsystem nach Anspruch 1, **dadurch gekennzeichnet, dass** die elektronischen Einrichtungen das Ergebnis der Analyse oder das an den Anschlüssen der Hilfsspule anliegende Signal fernübertragen können.

## Revendications

1. Procédé de détection de pannes pour la détection d'un endommagement aux barres de cage de rotor et/ou aux bagues de court-circuit d'un moteur asynchrone, ledit moteur comprenant un stator (1) et un rotor (2), le stator comprenant une pluralité de dents de stator (4) et le rotor comprenant une pluralité de barres de cage de rotor, dans lequel le moteur fonctionne dans des conditions de charge quelconques, lesdites conditions de charge incluant des charges dont le couple antagoniste présente une composante oscillante ou pulsatoire, ledit moteur étant alimenté avec au moins un signal ayant une fréquence (f), dans lequel le procédé comprend les étapes consistant à :

mesurer le flux magnétique concaténé dans l'une des dents de stator de moteur et prendre ladite mesure en tant qu'indicateur de la présence d'endommagement infligés auxdites barres et/ou bagues de court circuit, dans lequel ledit flux magnétique est mesuré en déterminant la valeur de la force électromotrice induite par ledit flux dans les bornes d'une bobine auxiliaire (5) située autour de ladite dent de stator, et dans lequel la période du signal de ladite force électromotrice est déterminée par mesure de la durée entre les passages successifs par zéro dudit signal, et dans lequel la période du signal de ladite force électromotrice est comparée à la période correspondant à la fréquence (f) du signal d'alimentation en énergie du moteur, et en interprétant en tant qu'indicateur de la présence d'un endommagement infligé aux barres de cage de rotor et/ou aux bagues de court circuit dudit moteur le fait que la valeur de la période mesurée pour le signal de ladite force électromotrice ne coïncide pas avec ou n'est pas proche de la période correspondant à ladite fréquence (f).

2. Procédé selon la revendication 1, **caractérisé en ce que**, pour effectuer ladite comparaison, il est défini une valeur seuil au-dessus de laquelle le résultat de la comparaison est considéré comme un indicateur de la présence d'une panne.

3. Procédé selon la revendication 1, **caractérisé en ce que** le signal de la force électromotrice est mesuré en utilisant un instrument de mesure.

4. Procédé selon la revendication 3, **caractérisé en ce que** l'instrument de mesure est de nature numérique et **en ce que** la mesure obtenue de cette manière est transmise à un équipement informatisé de manière à diagnostiquer ladite mesure.

5. Système moteur comprenant un moteur asynchrone à cage d'écureuil, ledit moteur comprenant un rotor (2), logé à l'intérieur d'un stator (1) comprenant une pluralité de dents de stator (4) agencées radialement, dans lequel au moins un bobine auxiliaire (5) est disposée autour d'une des dents de stator (4), pour détecter un endommagement infligé aux barres de cage de rotor et/ou aux bagues de court circuit dudit moteur, lorsque le moteur fonctionne sous dans des conditions de charge quelconques, y compris des charges pulsatoires, ladite bobine auxiliaire état adaptée pour mesurer le flux magnétique concaténé sur ladite dent de stator, dans lequel la bobine auxiliaire (5) comprend deux bornes, accessibles depuis l'extérieur du moteur de manière à faciliter la connexion électrique d'un équipement de mesure externe à ces bornes, le système moteur comprenant en outre des moyens électroniques programmables prévus à l'extérieur du moteur, pour analyser le signal aux bornes de la bobine auxiliaire, lesdits moyens électroniques programmables étant configurés pour mettre en oeuvre le procédé défini à la revendication 1.

6. Système moteur selon la revendication 5, **caractérisé en ce que** ladite bobine auxiliaire est composée d'au moins une boucle d'un conducteur isolé.

7. Système moteur selon la revendication 5 ou 7, **caractérisé en ce que** la bobine auxiliaire est disposée sur l'extrémité intérieure de ladite dent de stator, sur l'extrémité extérieure de ladite dent de stator ou en toute position intermédiaire entre lesdites extrémités.

8. Système moteur selon la revendication 5 ou 7, **caractérisé en ce que** la bobine auxiliaire est disposée parallèlement à l'arbre du moteur.

9. Système moteur selon la revendication 1, **caractérisé en ce que** lesdits moyens électroniques peuvent transmettre à distance le résultat de l'analyse ou le signal présent aux bornes de la bobine auxiliaire.

FIG.1

a

b

FIG.2

FIG.3

FIG.4

FIG.5

FIG.6

MEASUREMENT OF THE FLUX IN A STATOR TOOTH WITH AUXILIARY COIL

↓

RESULT OF ELECTROMOTIVE FORCE INDUCED IN TERMINALS OF THE AUXILIARY COIL

↓

CALCULATION OF THE PERIOD OF THE ELECTROMOTIVE FORCE SIGNAL (Time between passes through zero)

↓

PERIOD T=1/f

PERIOD HAS FLUCTUATIONS IN RELATION TO T=1/f

↓

HEALTHY ROTOR

↓

THERE ARE ASYMMETRIES IN THE ROTOR

# FIG.7

FIG.8

**EP 2 113 780 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4808932 A
- US 3875511 A
- US 4136312 A